(19) Europäisches Patentamt
European Patent Office
Office européen des brevets

(11) **EP 2 310 954 B1**

(12) **FASCICULE DE BREVET EUROPEEN**

(45) Date de publication et mention
de la délivrance du brevet:
**30.11.2011 Bulletin 2011/48**

(21) Numéro de dépôt: **09800067.2**

(22) Date de dépôt: **23.07.2009**

(51) Int Cl.:
*G06F 15/80* (2006.01)     *G06T 1/20* (2006.01)
*G11C 19/18* (2006.01)     *H01L 27/146* (2006.01)
*G11C 19/38* (2006.01)

(86) Numéro de dépôt international:
**PCT/EP2009/059503**

(87) Numéro de publication internationale:
**WO 2010/010151 (28.01.2010 Gazette 2010/04)**

(54) **CIRCUIT DE TRAITEMENT DE DONNÉES À PROCESSEUR ÉLÉMENTAIRE, ENSEMBLE DE TRAITEMENT DE DONNÉES COMPORTANT UNE GRILLE DE TELS CIRCUITS, ET CAPTEUR MATRICIEL COMPORTANT UN TEL ENSEMBLE**

DATENVERARBEITUNGSSCHALTUNG MIT ELEMENTAREM PROZESSOR, DATENVERARBEITUNGSANORDNUNG MIT EINER REIHE AUS DERARTIGEN SCHALTUNGEN UND MATRIXSENSOR MIT EINER DERARTIGEN ANORDNUNG

DATA PROCESSING CIRCUIT WITH AN ELEMENTARY PROCESSOR, DATA PROCESSING ASSEMBLY INCLUDING AN ARRAY OF SUCH CIRCUITS, AND MATRIX SENSOR INCLUDING SUCH AN ASSEMBLY

(84) Etats contractants désignés:
**AT BE BG CH CY CZ DE DK EE ES FI FR GB GR HR HU IE IS IT LI LT LU LV MC MK MT NL NO PL PT RO SE SI SK SM TR**

(30) Priorité: **23.07.2008 FR 0855014**

(43) Date de publication de la demande:
**20.04.2011 Bulletin 2011/16**

(73) Titulaire: **Commissariat à l'Énergie Atomique et aux Énergies Alternatives 75015 Paris (FR)**

(72) Inventeur: **BERNARD, Thierry F-91370 Verrieres Le Buisson (FR)**

(74) Mandataire: **Le Forestier, Eric et al Cabinet Regimbeau 20, rue de Chazelles 75847 Paris Cedex 17 (FR)**

(56) Documents cités:
**FR-A- 2 583 602     FR-A- 2 683 348 JP-A- 7 028 988**

• **PAILLET F ET AL: "Low power issues in a digital programmable artificial retina" LOW-POWER DESIGN, 1999. PROCEEDINGS. IEEE ALESSANDRO VOLTA MEMORIAL WO RKSHOP ON COMO, ITALY 4-5 MARCH 1999, LOS ALAMITOS, CA, USA,IEEE COMPUT. SOC, US, 4 mars 1999 (1999-03-04), pages 153-161, XP010323916 ISBN: 9780769500195**

**Description**

L'invention concerne d'une façon générale les circuits de traitement de données issues d'un ensemble de sources de données tel qu'un capteur matriciel.

L'invention concerne également un capteur matriciel comprenant un ensemble de cellules de détection formant les sources de données et muni d'une pluralité de tels circuits de traitement.

Dans une application particulière, l'invention vise le traitement de données provenant de cellules de détection telles que des cellules photosensibles pour la vision artificielle, le capteur formant une rétine artificielle.

Les techniques de vision artificielle ont pour objectif de déterminer certaines caractéristiques réelles d'une scène observée, à partir des séquences d'images de cette scène qui sont fournies par une caméra, afin de réaliser, dans un délai plus ou moins court, des actions en relation avec ladite scène.

Depuis quelques années, de nombreux modèles de caméras sont numériques. Alors que les capteurs d'image fournissent naturellement des données analogiques, ces caméras numériques délivrent directement des images numérisées car elles intègrent des moyens de conversion analogique-numérique. Actuellement, un système de vision artificielle usuel comporte typiquement une caméra numérique et des ressources de traitement numérique de l'information, qui peuvent aller du simple ordinateur de bureau jusqu'à des calculateurs ou supercalculateurs spécialisés.

Ces différentes configurations dépendent de la complexité des tâches de vision à réaliser, qui se traduit par des algorithmes impliquant des calculs plus ou moins compliqués à effectuer sur les données.

La consommation d'énergie d'un système de vision usuel peut ainsi aller d'une dizaine à plusieurs centaines de Watts selon la solution retenue. On comprend que de tels niveaux de puissance consommée sont le plus souvent incompatibles avec une utilisation mobile, ou statique mais sans fil (notamment lorsqu'il est trop coûteux d'amener une alimentation électrique).

Un premier exemple peut être fourni dans le domaine de la surveillance. Il n'est en effet pas possible aujourd'hui de concevoir une caméra intelligente fonctionnant sur quelques piles du commerce et capable pendant plusieurs semaines d'observer un lieu de passage et d'y détecter et caractériser les mouvements de personnes ou de véhicules.

Un deuxième exemple peut être fourni en visiophonie ou visioconférence. Il serait en effet plus léger de transmettre entre téléphones portables un modèle animé du visage des utilisateurs qu'une séquence vidéo compressée, comme cela se pratique aujourd'hui. Mais la génération d'un tel modèle animé au niveau du téléphone demande un travail d'analyse des images successives difficilement compatible avec son autonomie énergétique.

Un troisième exemple concerne un robot mobile ou véhicule plus ou moins automatisé, où la vision artificielle, à partir d'images captées en spectre visible ou infrarouge, doit jouer un rôle prépondérant dans le pilotage assisté ou automatique, ou encore dans la préhension d'objets.

Dans cet exemple, même si une part de l'énergie motrice d'un véhicule peut être détournée vers des fonctions de vision, comme sur une voiture, la multiplication attendue du nombre de capteurs visuels exigera une certaine sobriété énergétique. Cette sobriété est d'autant plus critique sur véhicule ou robot de taille réduite, et plus encore sur objet volant, tel qu'un drone.

On a donc cherché à proposer des systèmes de vision particulièrement économes en énergie.

Pour cela une architecture connue consiste à mettre en oeuvre un processeur élémentaire (ci-après désigné par PE) destiné à être répété en chaque noeud selon une grille bidimensionnelle au sein d'un circuit intégré.

Cette grille bidimensionnelle correspond soit directement à l'image, avec un PE par pixel, soit à une version sous-résolue de l'image, avec un PE pour un petit groupe de pixels appelé macro-pixel, par exemple un bloc de 2x2 ou 4x4 pixels. Les PE sont pilotés par des signaux de commande qui peuvent être communs à tous les PE (mode dit SIMD pour Single Instruction Multiple Data) ou communs à des sous-familles de PE, notamment selon le brevet FR-A-2 778 764 (Bernard, Paillet et Mercier). Par ailleurs, chaque PE est capable de mémoriser les données correspondant à son (macro-)pixel, de communiquer avec ses plus proches voisins et peut faire des calculs sur ses données.

Pour de multiples tâches de vision, une telle architecture suffit à réaliser une part importante de la charge de calcul tout en ne faisant circuler les données que sur de petites capacités (au sens électrique) au fond d'un circuit intégré (l'énergie dissipée est proportionnelle à ces capacités), se chiffrant en dizaines de femtofarads ($10^{-14}$ F). Par rapport à un système de vision usuel, le gain énergétique est avec une telle architecture de l'ordre d'un facteur 100.

Sur la base de cette architecture de la grille bidimensionnelle de PE, on a donc également cherché à minimiser les pertes d'énergies pour communiquer avec l'extérieur de cette grille. Ainsi, pour amener des images sur la grille de PE, il a été proposé de rapprocher celle-ci du capteur matriciel d'images (capacités liées aux connexions).

Comme proposé dans JP-A-10 145 680 puis US-A-6 608 296 (Toyada et Ishikawa), on peut placer capteur matriciel d'images et grille de PE côte à côte, en prenant en sandwich des moyens de conversion analogique-numérique entre les deux. On peut également superposer le capteur matriciel d'images et une grille de PE, comme proposé antérieurement dans FR-A-2 583 602 (Devos, Garda et Zavidovique), ce qui revient à installer chaque PE au plus près de l'élément photosensible du pixel qui lui correspond.

On appelle le système ainsi obtenu une rétine artificielle, dont chaque pixel comporte un élément photosensible, un PE et, pour les relier, un dispositif de conversion analogique-numérique qui peut se limiter à un comparateur de tension.

Pour améliorer encore ces dispositifs, en termes de compacité, et pour minimiser l'énergie dépensée, tout en répondant aux autres contraintes du système à savoir un système capable de mémoriser des données binaires, d'en échanger avec ses voisins sur la grille, et de faire des calculs booléens universels (processeur), des efforts sont faits en particulier sur la manière dont les bits d'information sont mémorisés au sein du PE.

Des solutions ont déjà été apportées à ce problème.

Un premier mode de mémorisation à avoir été utilisé est le mode dit semi-statique : chaque bit d'information y est mémorisé au moyen de deux inverseurs rebouclés à travers des interrupteurs, constituant un système bistable (deux états d'équilibre stables). Différents montages ont été proposés notamment dans FR-A-2 583 602 (Devos, Garda et Zavidovique), FR-A-2 683 348 (Zavidovique, Bernard et Devos) et FR-A-2 7771 38 (Paillet, Mercier et Bernard). Mais une telle mémorisation semi-statique oblige à combiner des transistors de type différents, ce qui aboutit à des montages peu compacts malgré tous les efforts. Ceci constitue un handicap pour doter un PE d'une capacité mémoire significative, par exemple de plusieurs dizaines de bits.

Un mode de mémorisation impliquant une architecture plus compacte que le mode semi-statique est le mode dynamique, où une donnée est stockée sous la forme d'une tension aux bornes d'une capacité. En effet, la compacité est liée au fait que les transistors utilisés pour mémoriser un bit sont moins nombreux et surtout d'un même type. Mémorisé dynamiquement, un 0 logique (respectivement un 1 logique) sera représenté par une tension proche d'une certaine valeur V0 (respectivement V1). Pour savoir quelle donnée binaire figure sur une capacité, on emploie un circuit de lecture qui, grossièrement, détermine si la tension aux bornes de ladite capacité est plus proche de V0 ou de V1. L'information stockée sur une capacité peut aussi être vue comme une charge. Un défaut bien connu de la mémorisation dynamique est la nécessité de rafraîchir les données par lecture puis réécriture, en raison des courants de fuite parasites qui déchargent progressivement les capacités.

Le recours à la mémorisation dynamique au sein d'un PE de rétine artificielle a été initialement proposé dans JP-A-7 028 988 (Ishikawa et Yamada) et réutilisé notamment dans JP-A-8 212 073 (Takayanagi, Yamada, Nakagami et Ishikawa). Les montages proposés s'appuient sur une mémorisation à base de circuits à verrouillage (ou « latch » selon la terminologie anglo-saxonne) dynamiques, également connus sous le nom de cellules mémoire à 3 transistors. Ces cellules mémoire comportent leur propre circuit de lecture. L'avantage est que leur lecture est non destructive (la donnée peut être lue plusieurs fois sans être réécrite). L'inconvénient est que cette cellule exige un bus de lecture et un bus d'écriture distincts (partagés entre les différentes cellules mémoire) et deux signaux de commande individuels. Cela nuit à la compacité du PE (routage de signaux).

Une autre utilisation de la mémorisation dynamique au sein d'un PE de rétine est décrite dans P. Dudek and P.J. Hicks. "A General Purpose Processor-per-Pixel Analog SIMD Vision Chip". IEEE Transactions on Circuits and Systems-I: Fundamental Theory and Applications, 52(1):13-20, janvier 2005. Selon ce document, elle y est exploitée en cellule mémoire de courant. Mais l'objectif est de mémoriser une donnée analogique, et plusieurs transistors et signaux individuels de commande sont nécessaires à cette cellule mémoire.

Une autre utilisation encore d'une mémorisation dynamique au sein d'un PE répété selon une grille est présentée dans J.C. Gealow and C.G. Sodini. "A Pixel-Parallel Image Processor Using Logic Pitch-Matched to Dynamic Memory". IEEE Journal of Solid-State Circuits, 34(6):831-839, juin 1999. Dans ce travail mené au MIT, ia mémorisation d'une donnée binaire est faite sur une cellule mémoire dite à un transistor, alias cellule dRAM, simplement constituée d'une capacité reliée à un bus de lecture/écriture via un transistor commandé par un signal de commande. Cette cellule dRAM est extrêmement compacte, mais sa lecture est destructive.

Un objectif de l'invention est de proposer un circuit de traitement, basé sur un PE répété selon une grille au sein d'un circuit intégré, capable de mémoriser des données binaires, d'en échanger avec ses voisins sur la grille, et de faire des calculs booléens universels sur celles-ci, selon un pilotage externe commun, avec un encombrement minimal, tout en disposant d'un PE à caractère universel, c'est-à-dire capable de réaliser n'importe quel calcul booléen, donc n'importe quel calcul numérique, avec une efficacité raisonnable.

A cet effet, il est ainsi proposé selon un premier aspect de l'invention un circuit de traitement de données, caractérisé en ce qu'il comprend en combinaison :

- une unité de traitement de données comprenant deux circuits de transformation de signaux possédant chacun une entrée de signal et une sortie de signal, et une série d'interrupteurs commandés reliés aux entrées et aux sorties desdits circuits de transformation, ladite unité de traitement de données comprenant par ailleurs une entrée de signal binaire et une sortie de signal binaire,
- une unité de mémorisation comprenant une série de capacités reliées à un agencement de bus de mémoire via une autre série d'interrupteurs et aptes à mémoriser chacune une donnée binaire, le bus étant relié à l'unité de traitement,
- un ensemble d'entrées pour des signaux de commande des interrupteurs commandés,

l'unité de traitement de données étant apte à effectuer au moins les opérations suivantes en réponse à des séquences données de signaux de commande :

* écrire dans une capacité une donnée binaire appliquée sur l'entrée,
* lire dans une capacité une donnée binaire qui y est mémorisée, et l'appliquer à la sortie, et
* combiner logiquement des données binaires mémorisées dans au moins deux capacités.

Certains aspects préférés mais non limitatifs de ce circuit sont les suivants :

* les circuits de transformation sont des inverseurs ayant des réponses de type sigmoïde inversée.
* un premier inverseur a son entrée et sa sortie reliées à l'agencement de bus de mémoire chacune par l'intermédiaire d'un interrupteur commandé respectif.
* l'unité de traitement comprend uniquement deux inverseurs avec l'entrée de l'un reliée à la sortie de l'autre via un premier interrupteur commandé et l'entrée de l'autre reliée à la sortie de l'un via un second interrupteur commandé.
* le circuit comprend une entrée pour une tension de compensation qui est reliée via une capacité à l'entrée du premier inverseur.
* le circuit comprend une entrée pour une tension de compensation reliée via une capacité à l'agencement de bus de mémoire.
* la tension de compensation est variable.
* au moins le premier inverseur est constitué par un comparateur dont une entrée positive reçoit une tension de seuil.
* la tension de seuil est variable.
* le ou chaque comparateur est réalisé à l'aide d'un amplificateur opérationnel à transconductance.
* le circuit est apte à combiner logiquement, au niveau d'un premier circuit de transformation, les données binaires mémorisées dans des capacités en réponse à des signaux de commande rendant passants des interrupteurs commandés de l'unité de mémorisation pour connecter électriquement lesdites capacités à l'agencement de bus mémoire.
* le type de combinaison logique varie en fonction de la valeur de la tension de compensation.
* le type de combinaison logique varie en fonction de la valeur de la tension de seuil.
* les capacités sont agencées en ligne, avec un bus de mémoire unique et un interrupteur unique associé à chaque capacité.
* les capacités sont agencées en matrice, avec deux ensembles de lignes de bus s'intersectant et une paire d'interrupteurs commandés associée à chaque capacité.
* la paire d'interrupteurs comprend un premier interrupteur dont les deux bornes de signal sont reliées entre la capacité et le bus, et un second interrupteur dont les deux bornes de signal sont reliées entre une première ligne de commande et l'entrée de commande du premier interrupteur, et dont l'entrée de commande est reliée à une seconde ligne de commande.
* l'agencement de bus de mémoire est réalisé par segmentation du bus en plusieurs parties séparées par des interrupteurs commandés respectifs.

Selon un deuxième aspect de l'invention, on propose un ensemble de traitement de données, caractérisé en ce qu'il comprend une grille de circuits de traitement chacun définis comme ci-dessus, et un dispositif de commande apte à appliquer auxdites entrées pour signaux de commande des signaux de commande communs à l'ensemble des circuits de traitement.

Certains aspects préférés mais non limitatifs de cet ensemble de traitement sont les suivants :

* chaque unité de traitement de données est apte à transférer des données binaires vers une unité de traitement voisine par l'intermédiaire d'un interrupteur commandé.
* chaque unité de traitement de données est apte à transférer des données binaires vers des unités de traitement voisines et à recevoir de celles-ci des données binaires via un jeu de ports connectés à un jeu de capacités de son unité de mémorisation associée.
* le jeu de ports relie l'unité de traitement à quatre unités de traitement voisines agencées aux quatre points cardinaux, les ports des unités voisines étant reliés entre eux deux à deux.
* le jeu de ports relie l'unité de traitement à huit unités de traitement voisines agencées aux quatre points cardinaux et aux points cardinaux secondaires, les ports des unités voisines étant reliés entre

eux quatre à quatre.

On propose enfin selon un troisième aspect un capteur matriciel, caractérisé en ce qu'il comprend un ensemble de cellules de détection formant sources de données, et un ensemble de traitement tel que défini ci-dessus.

Certains aspects préférés mais non limitatifs de ce capteur sont les suivants :

* il comprend en association avec chaque cellule un circuit de conversion délivrant pour chaque mesure une succession de valeurs binaires représentatives de la quantité mesurée.
* les cellules sont des cellules photosensibles.

D'autres caractéristiques, buts et avantages de la présente invention apparaîtront à la lecture de la description détaillée qui va suivre, et en regard des dessins annexés, donnés à titre d'exemples non limitatifs et sur lesquels :

la Figure 1 illustre l'architecture générale d'un processeur élémentaire selon une mise en oeuvre de la présente invention,
la Figure 2 illustre deux formes possibles de circuit de transformation utilisé dans un processeur élémentaire de la présente invention,
la Figure 3 illustre des interconnexions autorisant une communication entre un processeur élémentaire et ses 4 plus proches voisins,
la Figure 4 illustre des interconnexions autorisant une communication entre un processeur élémentaire et ses 8 plus proches voisins,
la Figure 5 illustre deux montages possibles pour l'unité de mémorisation selon que celle-ci est de structure linéaire (à gauche) ou matricielle (à droite),
la Figure 6 illustre une première forme de réalisation d'une dRAM à structure matricielle, et
la Figure 7 illustre un processeur élémentaire pourvu d'une dRAM à structure matricielle améliorée par segmentation du bus dRAM.

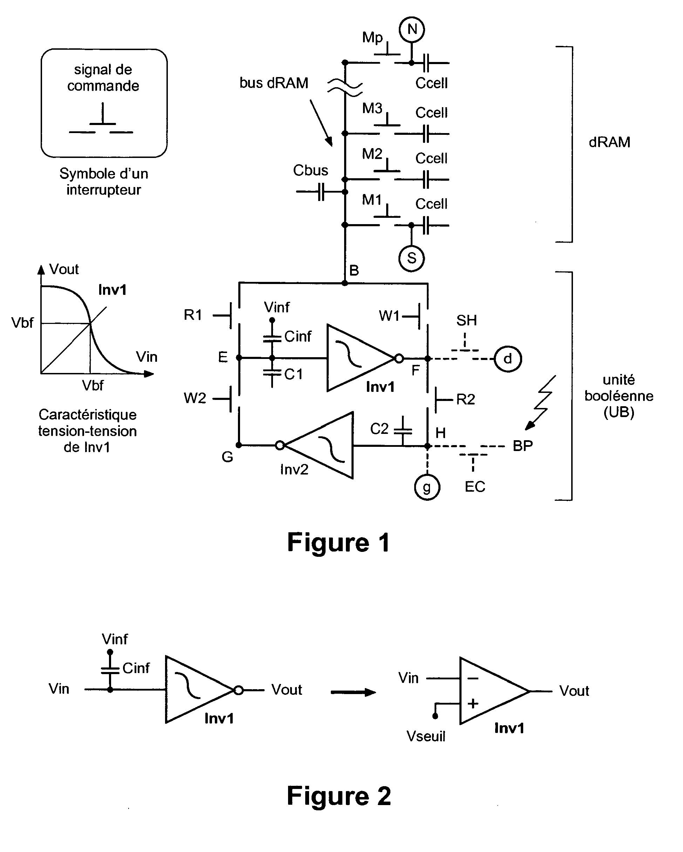

On va maintenant décrire un processeur élémentaire (PE) selon l'invention, dont l'architecture générale est présentée sur la Figure 1.

Ses éléments constitutifs sont des inverseurs ici au nombre de deux notés Inv1 et Inv2 et constituant les deux circuits de transformation, des capacités Ccell, C1, C2 et Cinf, et des interrupteurs Mi, R1, W1, R2, W2, interconnectés entre eux. Il existe également une capacité parasite intrinsèque notée Cbus.

Il s'agit d'opérateurs dont chacun peut être réalisé de différentes manières. Les inverseurs, dont la caractéristique tension-tension est de type sigmoïde inversée comme rappelé sur leur symbole ainsi qu'en bas à gauche de la Figure 1, peuvent être des inverseurs CMOS ou des montages de type amplificateurs opérationnels montés en comparateur, des OTAs notamment (amplificateurs opérationnels à transconductance). Les interrupteurs, pour des raisons de compacité, sont avantageusement réalisés par des transistors d'un seul type N ou P (par opposition à leur réalisation conventionnelle sous forme de deux transistors complémentaires en parallèle), et ont dans ce cas pour propriété de ne pas transmettre correctement toutes les tensions, et d'injecter dans le circuit des charges lors de leur ouverture-fermeture. On les considérera néanmoins comme idéaux dans une large partie de la présente description, afin de ne pas obscurcir celle-ci.

Par convention, un interrupteur est passant si son signal logique de commande est à 1 : on dit alors dudit signal qu'il est activé. Les signaux de commande apparaissant sur la Figure 1 sont communs entre une série de processeurs élémentaires.

Parmi les capacités représentées, certaines sont des capacités natives comme Cbus, C1 et C2, tandis d'autres sont volontairement mises en place comme Cinf, dont on verra le rôle plus loin, ou les capacités Ccell de mémorisation de valeurs. Ces dernières, que l'on appellera dans la suite « capacités dRAM » (pour mémoire vive dynamique), peuvent être de type diode, MOS, et aussi inter-couches (métal, poly) selon la technologie employée.

Sur la Figure 1, toutes les capacités, sauf Cinf, sont représentées par souci de simplification avec une borne non connectée : en pratique, cette borne est connectée à la masse, à la tension d'alimentation, ou à une autre tension fixe.

De même que les interrupteurs, les capacités sont considérées idéales dans une large partie de la présente description, c'est-à-dire linéaires.

La Figure 1 fait également apparaître des ports de communication, sous forme de lettres encerclées (d, g, S, N) dont le rôle sera décrit plus loin.

L'architecture générale du processeur élémentaire (PE) est structurée en deux unités : en haut de la Figure 1 une unité de mémorisation (dRAM), et en bas de cette même figure une unité de traitement de données (unité booléenne ou UB), La dRAM est formée d'un ensemble de p capacités de mémorisation, de capacité Ccell, dont l'une des bornes est connectée à la tension fixe précitée (du côté droit) et l'autre à un interrupteur, dit interrupteur d'accès, noté Mi (où i est un indice allant de 1 à p), connectant à un noeud commun appelé « bus dRAM ». L'association d'une capacité dRAM Ccell et de son interrupteur d'accès Mi est appelée « cellule dRAM ». La i-ème capacité dRAM en partant du bas est donc accessible depuis le bus dRAM en activant le signal Mi qui commande l'interrupteur Mi associé (par convention, on désigne tout au long de la présente description par le même signe de référence un interrupteur commandé et le signal qui commande cet interrupteur).

Le bus dRAM présente une capacité électrique naturelle Cbus, qui est ici parasite et donc à minimiser ; mais en pratique, la valeur de Cbus demeure largement supérieure à celle de Ccell.

L'unité booléenne (UB) est un circuit de lecture/écriture de la dRAM. Elle comporte 5 noeuds nommés B, E, F, G et H. Le noeud B est relié au bus dRAM.

Outre sa fonction de lecture/écriture, l'UB est capable de réaliser des calculs booléens entre plusieurs grandeurs binaires, réalisés de façon analogique, comme on le décrira dans la suite.

L'unité booléenne comprend quatre interrupteurs commandés R1, W1, R2 et W2, les signaux de commande associés étant ici encore désignés de la même manière.

Les différents composants de l'unité booléenne, tels que mentionnés dans ce qui précède, sont agencés de la façon suivante : l'inverseur Inv1 a son entrée reliée au noeud E et sa sortie reliée au noeud F ; la capacité C1 est reliée au noeud E ;l'interrupteur commandé R1 est monté entre le noeud E et le noeud B connecté au bus dRAM ; l'interrupteur W1 est monté entre les noeuds B et F ; l'interrupteur W2 est monté entre les noeuds E et G ; l'interrupteur R2 est monté entre les noeuds F et H ; l'inverseur Inv2 a son entrée reliée au noeud H et sa sortie reliée au noeud G ; la capacité C2 est reliée au noeud H ; la capacité Cinf est reliée soit au noeud B, c'est-à-dire au bus dRAM, soit au noeud E, c'est-à-dire l'entrée de l'inverseur Inv1 ; le noeud H peut constituer une entrée du processeur élémentaire, tandis que le noeud F peut constituer sa sortie.

Au sein de l'unité booléenne, les capacités natives C1 et C2 jouent un rôle de mémoires dynamiques et permettent de conserver des tensions pendant que les noeuds E et H sont laissés en haute impédance.

Le fonctionnement du processeur élémentaire de l'invention repose sur des séquences d'activation et désactivation de signaux de commande, qui ferment et ouvrent les différents interrupteurs.

Pour décrire ces signaux et leurs actions, on adopte ici une notation concise. Soit X un signal de commande quelconque. On note « X » l'activation de X (sa mise à 1, correspondant à la fermeture d'un interrupteur) et « X' » sa désactivation (sa mise à 0, correspondant à l'ouverture de l'interrupteur). Différents signaux activés ou désactivés simultanément sont reliés par des tirets, tandis que le point-virgule sépare les actions nécessairement successives. Ainsi par exemple, la séquence « R1-W1 ; W1' » désigne l'activation simultanée des signaux de commande R1 et W1, suivie de la désactivation de W1. Par ailleurs, on utilise la notation « Reset » pour désigner la désactivation de tous les signaux de commande.

La Figure 1 se limite à illustrer la coopération entre l'unité booléenne UB et dRAM au sein du processeur. Pratiquement, certains des noeuds B, E, F, G et H de l'unité booléenne peuvent recevoir d'autres connexions pour d'autres usages.

Par exemple, si le processeur élémentaire objet de l'invention est utilisé au sein du pixel d'une rétine, on ajoute typiquement un interrupteur commandé par un signal EC pour amener sur le noeud H un signal binaire BP en provenance de l'élément photosensible, comme cela est indiqué en tiretés sur la Figure 1. Ce signal BP peut, classiquement, être le résultat d'une comparaison entre la tension d'une photodiode et un signal externe variable ou, plus généralement, véhiculer une succession de valeurs binaires représentatives d'une grandeur physique captée.

Que l'on soit dans le cas d'une rétine ou non, une autre fonction importante pour une grille de processeurs élémentaires est l'entrée/sortie de jeux de données d'images ou autres depuis/vers l'extérieur. Cette fonction peut être assurée par un registre à décalage à sens unique chaînant les unités booléennes dans chaque ligne de processeurs élémentaires de la grille.

A cet effet, on considère le noeud H comme un port de communication g (pour gauche) et on connecte le noeud F à un port de communication d (pour droite) à travers un interrupteur commandé par le signal SH, comme dessiné en tiretés sur la Figure 1.

Par ailleurs,au sein de la grille de processeurs élémentaires (PE), le port d de tout PE est connecté au port g de son voisin de droite. Alors, la séquence « SH ; SH' ; W2 ; W2' » décale d'un PE vers la droite la donnée binaire présente sur le noeud F (sortie de Inv1), les autres signaux étant désactivés. Ceci a donc pour effet de translater d'un pixel vers la droite l'image binaire délivrée par les inverseurs Inv1 de tous les PE. En répétant la séquence, les différentes données élémentaires telles que celles d'une image sort colonne après colonne sur le bord droit de la grille de PE.

Une telle configuration permet également d'introduire des données telles que des données d'image colonne par colonne sur le bord gauche de la grille.

L'interaction entre unité booléenne et dRAM, au coeur du fonctionnement du processeur élémentaire de la Figure 1, va maintenant être décrite en détail.

*Préambule*

Avant de décrire les séquences de lecture, écriture et calcul, on va examiner l'effet de la courte séquence : « Reset ; R1-W1 ; W1' »

Cet effet essentiel, analogique, sera au coeur des opérations de lecture et de calcul présentées plus loin : tous les signaux de commande étant remis à 0, l'activation de R1 et W1 place Inv1 en boucle fermée, tout en le connectant au bus dRAM. Cette mise en boucle fermée de Inv1 amène ses tensions d'entrée Vin et Vout à une même valeur Vbf qui est à la fois l'abscisse et l'ordonnée du point d'intersection entre la caractéristique tension-tension de Inv1 et la première diagonale entre les axes Vin et Vout.

Cette situation est représentée graphiquement en bas à gauche de la Figure 1 : Vbf correspond en pratique à la zone la plus pentue de la caractéristique tension-tension de Inv1. C'est une zone qui peut correspondre à des courants électriques importants, en particulier avec des inverseurs CMOS : l'homme du métier saura les limiter, soit en réduisant l'écart entre tensions d'alimentation et de masse utilisées par Inv1, soit par usage d'un montage limité en courant.

En fin de séquence, lorsque W1 est désactivé (commande W1'), l'opérateur Inv1 repasse en boucle ouverte mais son entrée demeure connectée au bus dRAM et la tension y demeure égale à Vbf (on rappellera ici que les injections de charge par ouverture/fermeture d'interrupteurs sont négligées à ce stade, étant observé qu'elles ne changent rien au principe de fonctionnement). Dans ces conditions, la tension de sortie Vout demeure elle aussi à Vbf.

Partant de cette situation, toute variation légère de la tension d'entrée par rapport à Vbf va se traduire par une variation nettement plus grande sur la sortie Vout. Cette propriété peut être exploitée pour amplifier une faible variation de tension du bus dRAM.

*Lecture*

La séquence suivante, dite de lecture, débute par celle présentée ci-dessus en préambule et réalise finalement la lecture de la i-ème capacité dRAM :

« Reset ; R1-W1 ; W1' ; Mi ; Mi' ; R2 ; R2' ; R1' »

Cette lecture est destructive : lorsque Mi est activé, les charges présentes sur la i-ème capacité dRAM, de valeur Ccell et sous une tension Vcell, se mélangent avec celles présentes sur le bus dRAM et l'entrée de Inv1, de capacité Ctot=Cbus+C1+Cinf (capacité totale de lecture) et sous la tension Vbf. Posons $\Delta V$=Vcell-Vbf. Alors le mélange de charges provoque sur le bus dRAM une variation de tension bien plus faible $\Delta$Vbus = [Ccell/(Ccell+Ctot)]·$\Delta V$.

En pratique, Ccell étant petite devant Ctot, on peut arrondir $\Delta$Vbus $\approx$ (Ccell/Ctot)·$\Delta V$. Cette petite variation est tout ce qu'il reste de la donnée lue, et c'est l'amplification apportée par Inv1 qui permet de la restaurer.

Dans ce but, le gain de Inv1, c'est-à-dire la pente de sa caractéristique tension-tension autour de Vbf, doit être de l'ordre de Ctot/Ccell, ou supérieur.

*Ecriture directe*

Une fois une donnée installée en sortie de Inv2, elle peut être écrite sur la j-ème capacité dRAM, grâce à la séquence suivante :

« W2-R1-Mj ; Mj' ; R1'-W2' »

*Ecriture complémentée*

Que la séquence ci-dessus, dite d'écriture directe, ait été exécutée ou pas, le complément de la donnée lue peut être écrit sur la k-ième capacité dRAM, grâce à la séquence suivante, appelée séquence d'écriture complémentée :

« W2-W1-Mk ; Mk' ; W1'-W2' »

*Ecriture multiple*

Que ce soit dans la séquence de lecture ou les deux séquences d'écriture, le signal M (ici et par la suite, M désigne un ou plusieurs signaux parmi M1 à Mp) commandant l'accès à la capacité dRAM subit un créneau en ce sens qu'il s'active, puis se désactive au temps suivant. Les mêmes séquences peuvent être utilisées mais en appliquant un créneau sur plusieurs signaux M simultanément. Avec les instructions d'écriture, cela permet une écriture multiple. Par exemple, l'instruction suivante écrit la donnée installée en sortie d'Inv2 sur les capacités dRAM numéros i et j :

« W2-R1-Mi-Mj ; Mi'-Mj' ; R1'-W2' »

*Lecture multiple et calcul booléen*

Si l'on fait de même au sein d'une instruction de lecture, c'est-à-dire si on lit plusieurs cellules simultanément, cela réalise un calcul booléen. Comme on le comprendra plus loin, le cas le plus simple à examiner est celui d'un calcul sur les 3 données binaires Di, Dj et Dk contenues dans les capacités dRAM numéros i, j et k (trois indices distincts entre 1 et p), réalisé en utilisant la séquence suivante :

« Reset ; R1-W1 ; W1' ; Mi-Mj-Mk ; Mi'-Mj'-Mk' ; R2 ; R2' ; R1' »

Il s'agit bien d'une variante de la séquence de lecture présentée plus haut, où on lit 3 capacités au lieu d'une (la seule différence portant sur les signaux M) et dont on note qu'elle est également destructive. Le résultat obtenu est nécessairement une fonction de Di, Dj et Dk, que l'on va identifier ci-après.

Plus haut, on a appelé V0 et V1 les tensions correspondant respectivement à des 0 et 1 logiques sur les capacités dRAM. Avec les instructions d'écriture présentées et des composants idéaux, V0 et V1 sont censées être les tensions de sortie basse et haute de Inv2. Mais ce n'est pas le cas en pratique dans le cas où les interrupteurs sont à un seul transistor.

Dans cette perspective, supposons simplement V0 et V1 symétriquement placés de part et d'autre de Vbf. On peut alors nommer ΔV=V1-Vbf=Vbf-V0. D'autre part, le fait que Ccell soit petite devant Ctot permet des approximations. Par des calculs qu'il est inutile de reproduire ici, il s'avère que la connexion du bus aux 3 capacités dRAM par activation de Mi, Mj et Mk provoque une variation de sa tension (par rapport à Vbf) proche de :

$$(2\Sigma-3)\cdot(Ccell/Ctot)\cdot\Delta V$$

où Σ est la somme arithmétique des 3 données binaires Di, Dj et Dk.

En d'autres termes, Σ est le nombre de données à 1 parmi les 3. Donc, si Σ=2 ou 3, la séquence ci-dessus fournit un 1 logique en sortie de Inv2. Mais si Σ=0 ou 1, elle fournit un 0 logique. Le calcul réalisé est celui de la fonction booléenne bien connue appelée « majorité » (retenue sortante dans un additionneur binaire complet) : Maj(Di, Dj, Dk).

La mise en jeu de la somme Σ ci-dessus a un caractère fondamental puisque, lorsque les charges provenant de différentes capacités dRAM se mélangent, il est clair que seule leur somme arithmétique peut encore être estimée. Le calcul ci-dessus est donc typique de ce qu'on appelait anciennement la logique à seuil.

En supprimant Mk et Mk' de la séquence précédente, on obtient la variante de l'instruction de lecture qui lit les 2 capacités dRAM i et j. La variation de tension obtenue (par rapport à Vbf) est alors :

$$\Delta Vbus \approx (2\Sigma-2)\cdot(Ccell/Ctot)\cdot\Delta V$$

Cette variation est toutefois nulle si Σ=1 (c'est-à-dire pour Di≠Dj), entraînant l'apparition d'une donnée indéterminée à la sortie d'Inv2, dont le niveau logique est mal établi.

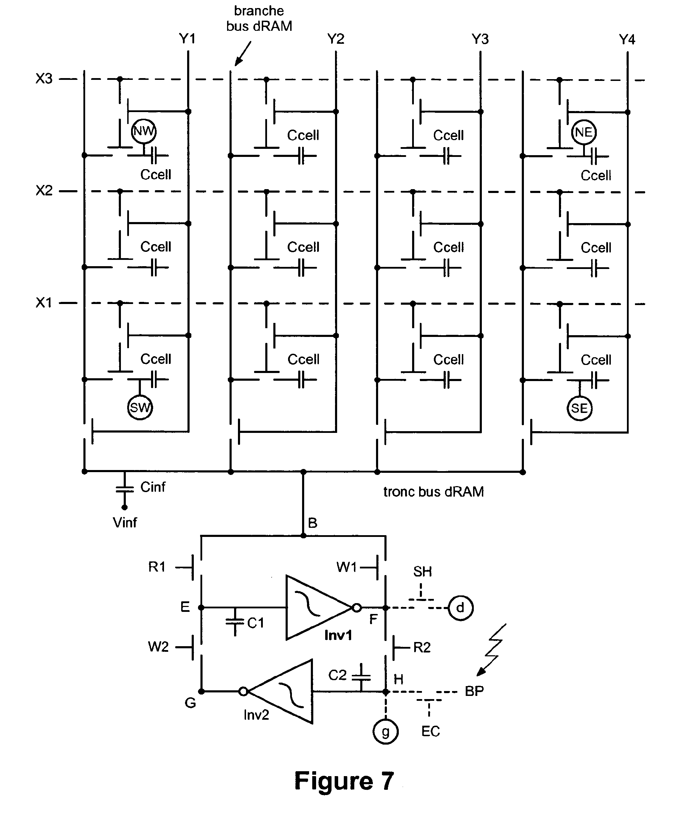

Pour pallier cette difficulté, on peut avantageusement exploiter un effet d'influence capacitive, en prévoyant dans le circuit une capacité dite d'influence Cinf, dont une borne est connectée soit à l'entrée de Inv1 (noeud E), comme dessiné sur la Figure 1, soit sur le bus dRAM (noeud B), comme dessiné sur la Figure 7. La tension imposée à l'autre borne de Cinf est la tension de compensation Vinf, que l'on utilise comme un signal analogique. En faisant varier Vinf d'un écart ΔVinf (hausse ou baisse de tension), on provoque sur le bus dRAM et l'entrée de Inv1 une variation de tension qui, si elle est suffisante, permet d'obtenir finalement une grandeur binaire fiable en sortie de Inv2. On adopte donc la nouvelle séquence suivante, où ΔVinf désigne alors l'action même de faire varier la tension de compensation Vinf de ΔVinf :

« Reset ; R1-W1 ; W1' ; ΔVinf ; Mi-Mj ; Mi'-Mj' ; R2 ; R2' ; R1' »

L'action ΔVinf constitue en fait une commande et l'on notera qu'elle peut occuper une autre position dans la séquence, pourvu qu'elle soit entre W1' et R2', et qu'elle peut éventuellement être exécutée simultanément avec une autre action élémentaire.

D'autres approches peuvent être envisagées pour lever l'ambiguïté en sortie de Inv2. En particulier, on peut avantageusement exploiter la capacité parasite de certains interrupteurs pour lui faire jouer « gratuitement » le rôle de Cinf, et notamment la capacité des interrupteurs R1, Mi ou Mj. Dans ce cas, certains de ces signaux auraient à subir des variations intermédiaires de tension entre leurs niveaux logiques habituels, variations qui remplaceraient fonctionnellement ΔVinf dans la séquence précédente.

Dans la forme de réalisation où une capacité d'influence Cinf est installée, il est préférable d'en minimiser la valeur, ce qui demande de maximiser ΔVinf. Mais ΔVinf doit rester réglable face aux incertitudes technologiques, et donc demeurer suffisamment en deçà de la différence de tension entre alimentation et masse.

*OU logique*

En réglant la valeur de Cinf pour que ΔVinf produise par lui-même une variation de tension du bus dRAM proche de (Ccell/Ctot)·ΔV, on obtient :

$$\Delta Vbus \approx (2\Sigma-1)\cdot(Ccell/Ctot)\cdot\Delta V$$

ce qui réalise une fonction booléenne de OU logique entre les données Di et Dj. Le choix suggéré pour Cinf garantit en fait les plus grandes marges de fonctionnement possible face aux incertitudes technologiques et conditions opératoires.

*ET logique*

D'autre part, si l'on inverse le signe de $\Delta$Vinf par rapport au cas du OU logique (Vinf varie donc de façon opposée), alors on a :

$$\Delta Vbus \approx (2\Sigma-3)\cdot(Ccell/Ctot)\cdot\Delta V$$

ce qui réalise une fonction de ET logique entre Di et Dj.

On comprend donc que l'agencement de l'unité booléenne de l'invention en coopération avec la dRAM permet de réaliser sans composant supplémentaire, en plus des fonctions de lecture et d'écriture précitées, les fonctions booléennes OU et ET logique à deux entrées, selon un aspect important de l'invention.

De plus, grâce à la disponibilité également décrite plus haut de la fonction de complémentation par écriture complémentée, on réalise au final un processeur élémentaire universel en termes de calcul booléen.

Il est à noter que, étant donné le caractère destructif des séquences de lecture et de calcul, on se servira d'écritures, multiples ou non, complémentées ou non, pour rafraîchir voire dupliquer en dRAM toute donnée devant être lue, ou devant participer à un calcul, une ou plusieurs fois, dans le futur.

*OU logique à trois entrées*

En combinant la lecture de 3 capacités dRAM et l'influence capacitive sus-décrite, on peut mettre en oeuvre la séquence suivante :
« Reset ; R1-W1 ; W1' ; $\Delta$vinf ; Mi-Mj-Mk ; Mi'-Mj'-Mk' ; R2 ; R2' ; R1' »

On a vu plus haut que cette séquence calcule la fonction majorité si $\Delta$Vinf=0 (c'est-à-dire si la tension de compensation Vinf ne varie pas). Mais si Cinf et $\Delta$vinf étaient réglés pour décaler Vbus de $2\cdot(Ccell/Ctot)\cdot\Delta V$ à eux seuls, c'est-à-dire deux fois plus que ci-dessus, alors on aurait :

$$\Delta Vbus \approx (2\Sigma-1)\cdot(Ccell/Ctot)\cdot\Delta V$$

ce qui réalise le OU logique entre les 3 données Di, Dj et Dk.

*ET logique à trois entrées*

D'autre part, en adoptant la valeur opposée pour $\Delta$Vinf, on obtiendrait $\Delta Vbus \approx (2\Sigma-5)\cdot(Ccell/Ctot)\cdot\Delta V$, ce qui correspond au ET logique entre les 3 données.

L'influence capacitive sur l'entrée de Inv1 ou sur le bus dRAM permet donc de réaliser différents types de calculs sur trois données binaires, par lecture simultanée de leur capacité dRAM correspondante. Ce sont toutefois des fonctionnalités optionnelles étant donné l'universalité déjà acquise du PE proposé. Elles peuvent être utiles mais elles ont un coût : doubler la valeur de Cinf. Par extension du procédé, il est possible de réaliser des calculs sur plus de 3 données binaires, en augmentant plus encore la valeur de Cinf, si l'homme du métier le juge pertinent en tenant compte des autres contraintes (dans une autre variante présentée plus bas, le surcoût capacitif pour réaliser des calculs sur plus de 2 données binaires disparaîtra car on n'utilisera plus de capacité d'influence).

*Constantes logiques*

Un autre intérêt de l'influence capacitive est de pouvoir fabriquer des constantes logiques ex nihilo au sein de l'unité booléenne, en utilisant la séquence suivante :
« Reset ; R1-W1 ; W1' ; $\Delta$Vinf ; R2 ; R2' ; R1' »

Selon que $\Delta$Vinf est (suffisamment) positif ou négatif, un 1 ou un 0 logique est obtenu en sortie de Inv2.

Dans toutes les séquences qui ont été présentées, il est à noter que les activations ou désactivations simultanées peuvent en variante être rendues séquentielles avec un ordre quelconque, par exemple pour éviter des appels de courants ou des effets capacitifs excessifs. D'autre part, tous les signaux de commande n'ont pas besoin d'être désactivés en fin de séquence, selon la manière dont sont enchaînées ces séquences, qui peuvent être vues comme autant d'instructions. Les séquences présentées ne constituent donc qu'une base et peuvent évoluer selon les critères d'optimisation retenus.

Une importante variante à l'influence capacitive sur l'entrée de Inv1 ou sur le bus dRAM, permettant d'obtenir le même jeu de fonctionnalités sans utiliser de capacité d'influence, consiste à faire varier latéralement la caractéristique tension-tension de Inv1. Il s'agit plus précisément d'en décaler la partie la plus pentue, vers la droite ou la gauche. Pour cela, une solution simple consiste à utiliser pour Inv1 non pas un inverseur CMOS standard mais un comparateur entre l'entrée habituelle de Inv1 et une tension de seuil Vseuil, appliquée sur l'entrée positive pour conserver à Inv1 son caractère inverseur, comme illustré sur la partie droite de la Figure 2.

Avec un tel montage, la caractéristique tension-tension présente sa portion quasi-verticale pour Vin=Vseuil. D'où Vbf=Vseuil. On peut donc régler directement Vbf, par exemple pour positionner sa valeur exactement entre V0 et V1, comme cela avait été supposé un peu plus haut. Alternativement, il est également possible de faire varier Vseuil pendant une séquence, comme on l'a fait plus haut avec Vinf, et il suffit alors de le faire dans des proportions plus faibles puisque l'action de $\Delta$Vseuil par rapport à la tension de bus est désormais directe alors que celle de $\Delta$Vinf était affaiblie par le facteur Cinf/Ctot. Accessoirement, cette plus forte efficacité de $\Delta$Vseuil par rapport à $\Delta$Vinf facilite les calculs sur trois données binaires ou plus, présentés plus haut.

Le comparateur peut être réalisé par un OTA (amplificateur opérationnel à transconductance). Un OTA est plus encombrant qu'un inverseur CMOS, mais il est naturellement limité en courant, ce qui répond à une préoccupation mentionnée plus haut. Il peut être avantageux d'utiliser le même montage pour Inv2.

Jusqu'ici, les interrupteurs et capacités ont été supposés idéaux. On va s'attacher maintenant à expliquer en quoi le processeur élémentaire est apte à fonctionner malgré des conditions réelles non idéales telles que : non-linéarité des capacités, injection de charges lors des ouvertures/fermetures d'interrupteurs, tensions amputées par les interrupteurs.

Avec des capacités linéaires, la tension du bus dRAM après connexion aux capacités dRAM est une fonction affine de $\Sigma$, comme on l'a vu. En d'autre termes la lecture de m capacités dRAM conduit la tension du bus dRAM à occuper m+1 niveaux possibles, équidistants les uns des autres. Si Vbf coïncide avec l'un de ces niveaux, il y a indétermination, ce cas étant rencontré pour m=2.

Pour éviter cette indétermination, on décale soit la tension d'entrée de Inv1, par influence capacitive en jouant sur Vinf, soit la caractéristique tension-tension de Inv1 en jouant sur Vseuil. Dans la description qui précède, pour m=2 puis m=3, les valeurs de $\Delta$Vinf ont justement été choisies pour se retrouver à mi-chemin entre 2 niveaux successifs parmi les m+1, cette approche fournissant les plus grandes marges de fonctionnement face aux incertitudes technologiques et opératoires. Avec des capacités non-linéaires, les m+1 niveaux vont légèrement se déplacer, sans demeurer équidistants. Pour un fonctionnement optimal, il faut donc simplement réajuster d'autant les différents décalages que l'on fait subir à la tension du bus dRAM, connecté à l'entrée de Inv1, ou à la caractéristique tension-tension de Inv1.

La deuxième perturbation par rapport aux conditions idéales est l'injection de charges par les interrupteurs. Ces injections provoquent bien sûr des décalages de tension. Il suffit d'exercer un décalage opposé pour les annuler, ce qui est possible comme ci-dessus en réajustant d'autant le décalage que l'on aurait normalement fait subir à la tension du bus dRAM, connecté à l'entrée de Inv1, ou à la caractéristique tension-tension de Inv1. Les injections de charge présentent cependant un petite part aléatoire : c'est pour rendre son effet négligeable que les signaux M s'activent puis se désactivent aussitôt dans les séquences de lecture présentées dans ce qui précède.

La troisième perturbation concerne les tensions amputées. En effet, les interrupteurs sont préférentiellement réalisés avec un unique transistor, donc d'un seul type (n ou p) en technologie CMOS. Or, les tensions les plus hautes ne passent pas via un transistor n, et les tensions les plus basses ne passent pas via un transistor p : les tensions sont donc amputées, par le haut ou le bas.

Dans ces conditions, V0 et V1, les tensions représentant 0 ou 1 logique en dRAM vont se retrouver excentrées, vers le bas ou vers le haut de la plage de tensions disponible. On notera que la structure de dRAM matricielle, qui sera décrite dans la suite selon un autre aspect de l'invention, renforcera cet effet : on pourra par exemple avoir V0=0V et V1=0,5V alors que le circuit fonctionne sous une tension d'alimentation de 3,3 V.

En pratique, il sera difficile ou impossible d'amener Vbf à la valeur médiane de tensions V0 et V1 aussi excentrées. Il faut dans telles conditions réaliser des décalages de tension accrus. Si l'on opte pour l'influence capacitive, cela demande une valeur plus importante de Cinf. Si on opte pour un montage comparateur pour Inv1 avec Vseuil sur l'entrée positive, cela demande de faire varier Vseuil durant les instructions de lecture, comme cela a été évoqué plus haut.

Une autre conséquence du resserrement entre V0 et V1 est une plus forte exigence sur le gain de Inv1.

Au final, il apparaît que le travail du circuit dans des conditions réelles perturbées par rapport aux conditions idéales peut être compensé par décalage de tension sur le bus dRAM connecté à l'entrée de Inv1 ou par décalage de la caractéristique tension-tension de Inv1. Une augmentation du gain de Inv1 peut également s'avérer nécessaire. Par ailleurs, de petites perturbations aléatoires peuvent être minimisées, donc demeurer sans conséquence, par choix d'un ordre adéquat dans les séquences.

Les séquences présentées ci-dessus démontrent que l'unité booléenne UB peut lire et écrire des données dans la dRAM, donc les rafraîchir, et même en fabriquer ex nihilo. Ces séquences montrent aussi que l'on dispose des opérateurs booléens fondamentaux, à savoir complément, ET logique, OU logique.

Finalement, en dépit de sa structure particulièrement simple, peu encombrante et économique, le processeur élémentaire selon cet aspect de l'invention présente un caractère universel au sens de Türing, ce qui lui permet de réaliser tout calcul booléen ou numérique. Il est également capable de réaliser des calculs moins triviaux avec une certaine efficacité, comme celui de la fonction majorité, utile notamment pour effectuer des additions numériques en mode bit-série.

La communication entre processeurs élémentaires (PE) est une autre fonctionnalité importante de la présente invention.

Dans la suite, pour la communication d'un PE avec ses 4 plus proches voisins, on parlera de réseau NEWS, pour **N**ord, **E**st, ouest (**W**est), **S**ud.

Il a été expliqué plus haut comment réunir les unités booléennes des PE d'une même ligne par un registre à décalage à sens unique par exemple vers la droite sur le circuit de la figure 1, c'est-à-dire dans la direction Est. Il est possible de procéder ainsi pour chacune des 4 directions cardinales. Cela ajoute au total 4 interrupteurs à une unité booléenne, chacun accompagné de son signal de commande, qu'il faut relier aux noeuds E, F, G ou H, entre 2 processeurs élémentaires voisins.

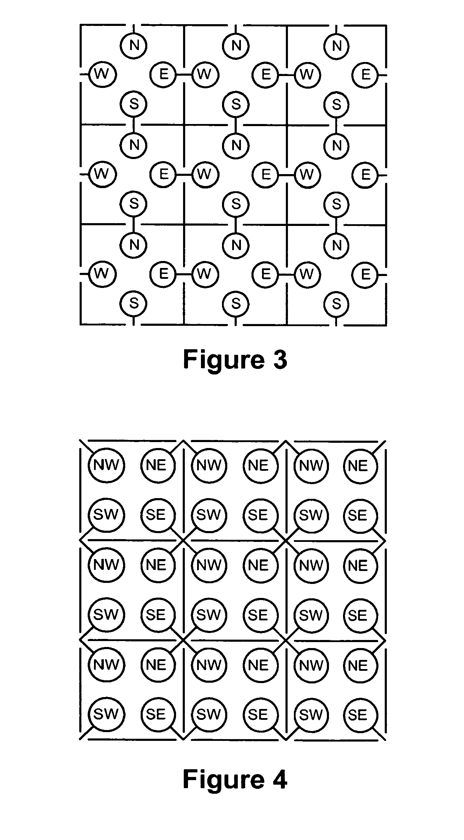

Une alternative au chaînage en registres à décalage consiste à partager une capacité de mémorisation entre les dRAM de toute paire de PE voisins. Pour expliquer et illustrer cette approche, décrite en référence à la Figure 3, on va recourir à la notion de ports de communication : chaque PE est considéré comme étant doté de 4 ports de communication : N, E, W, et S. Chaque port est connecté intérieurement et extérieurement au PE, de manière identique pour chaque PE. Intérieurement, chaque port est connecté à une capacité dRAM, comme le montre la Figure 1 pour les ports N et S seulement. Extérieurement au PE, les ports sont connectés entre eux de PE voisin à PE voisin, selon l'organisation de la Figure 3 : celle-ci montre une matrice de 3x3 PE, où chaque PE est délimité par un carré à l'intérieur duquel ne sont représentés que les ports de communication.

Avec cette organisation, le transfert d'une donnée entre PE voisins est réalisé par un simple jeu d'écriture-lecture sur une certaine capacité de la mémoire dRAM. Par exemple, avec les positions des ports N et S adoptées sur la Figure 1, le décalage d'une donnée vers le Nord consiste simplement à écrire cette donnée depuis l'unité booléenne vers la capacité dRAM d'indice p, puis à lire la capacité dRAM d'indice 1. Autrement dit, un décalage unitaire vers le Nord consiste à écrire sur le port N, puis à lire le port S. Réciproquement, un décalage unitaire vers le Sud consiste à écrire sur le port S, puis à lire le port N. En procédant de façon similaire avec des ports E et W, chaque PE peut ainsi communiquer avec ses 4 plus proches voisins sur la grille.

En mobilisant 4 capacités dRAM et leurs signaux d'accès associés, cette solution à base de mémoire partagée peut paraître aussi coûteuse en encombrement que celle à base de registre à décalage. Mais elle va s'avérer plus économique avec la dRAM à structure matricielle telle qu'on la décrira plus loin.

Une variante de la solution à mémoire partagée est proposée sur la Figure 4, sur laquelle chaque PE a toujours 4 ports, chacun connecté à une capacité dRAM différente, mais nommés du nom des points cardinaux secondaires respectivement NW, NE, SE et SW. Cette variante permet à chaque PE de communiquer avec ses 8 plus proches voisins, pour un surcoût insignifiant. Par exemple pour un décalage vers le Sud-Est, on écrit sur le port local SE, puis on lit sur le port NW du voisin situé au sud-ouest. Pour un décalage vers le Sud, on peut écrire sur le port SE local puis lire sur le port NE de la destination, ou encore écrire sur le port SW local puis lire sur le port NW de la destination.

C'est cette variante qui apparaît sur la structure de dRAM matricielle améliorée de la Figure 7, telle qu'on va la décrire plus loin.

Il a été montré plus haut que le processeur élémentaire (PE) de la présente invention a un caractère universel. En outre, les techniques de communication entre PE qui viennent d'être présentées garantissent de pouvoir translater des données binaires selon un vecteur quelconque en procédant par répétition de translations élémentaires dans une des directions NEWS.

Toutefois, le temps total de translation augmente avec la taille du vecteur et il peut se produire en outre des effets de bord. Finalement, chaque PE peut accéder à des données autour de lui, mais dans un voisinage de taille limitée par les effets de bord que l'on est prêt à accepter : on dit que les traitements sont à support borné.

Etant donné que la grille ou matrice de PE est pilotée en mode SIMD (Single Instruction, Multiple Data en terminologie anglo-saxonne), chaque PE accède aux mêmes voisins dans son repère relatif. Il en résulte une invariance en translation. En termes mathématiques, les traitements réalisables sur la grille de PE pilotée en mode SIMD sont commutatifs par rapport aux translations : en d'autres termes, réaliser une translation avant ou après un traitement donne le même résultat.

Ces deux propriétés que sont support borné et invariance en translation caractérisent le traitement d'image de bas niveau dans sa plus grande généralité. En font évidemment partie les opérateurs de filtrage linéaire, à base de noyau de convolution. Mais, avec un processeur élémentaire travaillant au niveau booléen, il est souvent plus approprié de recourir à des opérateurs dont la non-linéarité soit plus affirmée, tels que les filtres de rang ou les opérateurs de la morphologie mathématique.

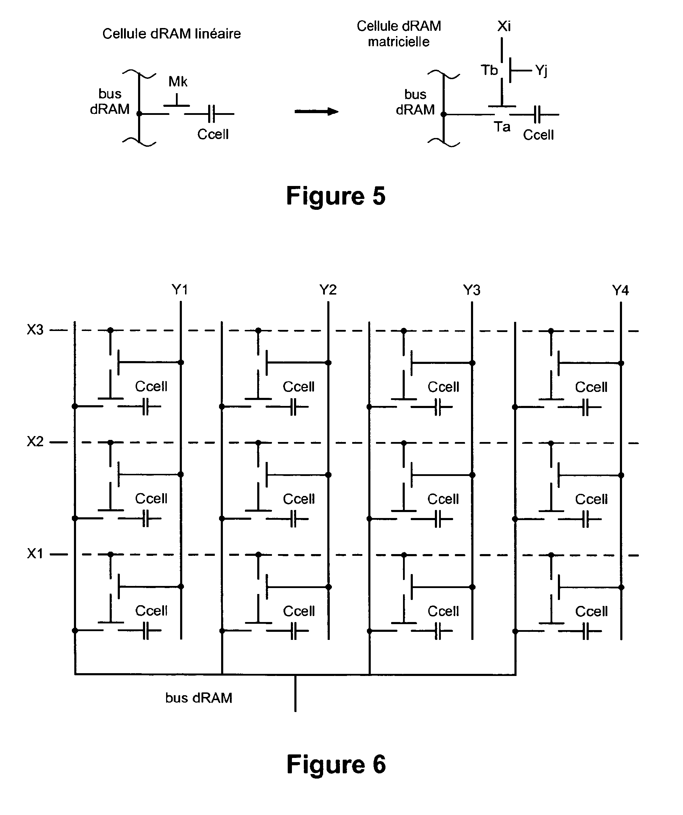

On va maintenant décrire en référence aux Figures 5 à 7 une mise en oeuvre de la présente invention avec un agencement matriciel des capacités formant la dRAM.

Tout d'abord, le PE tel qu'illustré sur la Figure 1 a été conçu pour occuper un minimum de place sur un circuit intégré, tout en ayant un caractère universel. Toutefois la dRAM y est organisée de manière linéaire : pour n capacités dRAM, il faut n signaux de commande Mi.

Pour n supérieur à une certaine valeur (typiquement 10), c'est le routage des signaux de commande Mi qui devient prépondérant lorsqu'on considère l'encombrement réel du circuit. Pour éviter cette situation, une solution est d'organiser la dRAM de manière matricielle, comme illustré sur les Figures 6 et 7 : au lieu d'être commandée par un signal unique Mk, chaque cellule dRAM va être assujettie à l'activation conjointe d'un signal Xi et d'un autre signal Yj selon une commande de type ligne/colonne. Il y a donc une famille de signaux Xi et une famille de signaux Yj. Au sein d'une même famille, les signaux seront routés parallèlement. En revanche, les deux familles seront routées perpendiculairement l'une à l'autre au sein de la dRAM, d'où la structure matricielle qui apparaît sur la Figure 6 et sur la Figure 7, où il existe une cellule dRAM pour chaque couple formé d'un signal Xi et d'un signal Yj.

Une structure de dRAM matricielle exige deux interrupteurs dans chaque cellule dRAM. Cependant, l'interrupteur d'accès associé à chaque capacité dRAM dans la structure linéaire peut difficilement être remplacé par deux interrupteurs en série pour obtenir la version matricielle, en raison de la capacité parasite substantielle qui apparaîtrait entre les deux interrupteurs et pourrait perturber le fonctionnement.

L'approche proposée ici est de cascader deux interrupteurs Ta et Tb comme cela est présenté sur la partie droite de la Figure 5 (dont la partie gauche illustre la cellule d'une dRAM linéaire, comme celle de la Figure 1), qui montre une cellule dRAM attachée à une section du bus dRAM. On voit sur cette figure que l'interrupteur Ta relie sélectivement la capacité Ccell au bus dRAM, en étant commandé par le signal Xi tel que transmis par l'interrupteur Tb lui-même commandé par le signal Yj.

Dans la mesure où chaque interrupteur est réalisé à l'aide d'un unique transistor (et donc d'un seul type), les tensions écrites sur capacité dRAM vont se trouver encore plus amputées que dans le cas d'une dRAM linéaire. Cette situation a été considérée et solutionnée plus haut.

Pour connecter au bus dRAM la cellule dRAM commandée conjointement par les signaux Xi et Yj, puis la déconnecter, il est nécessaire d'imbriquer les créneaux sur Xi et Yj, à l'aide de la séquence d'instructions suivante :
« Yj ; Xi ; Xi' ; Yj' »

La structure de dRAM matricielle est illustrée sur la Figure 6 par un exemple à 12 cellules où l'ensemble des Xi est {X1, X2, X3} et où l'ensemble des Yj est {Y1, Y2, Y3, Y4}. Les Yj sont amenés verticalement sur la figure, tandis que les Xi sont amenés horizontalement sur la figure selon des lignes représentées en tiretés. Le bus dRAM prend préférentiellement une structure de peigne telle qu'illustrée qui est la moins coûteuse à implanter.

Il est intéressant de comparer quantitativement les structures linéaire et matricielle de dRAM. Pour n capacités dRAM, la structure linéaire demande n interrupteurs (c'est-à-dire n transistors) et n signaux de commande, tandis que la structure matricielle demande 2n interrupteurs (c'est-à-dire 2n transistors) et environ $2\sqrt{n}$ signaux de commande. L'organisation matricielle est plus intéressante que l'organisation linéaire dès que n dépasse significativement 10.

Une autre structure matricielle possible pour la dRAM est illustrée sur la Figure 7. Elle est identique à celle de la Figure 6, sauf dans l'agencement du bus dRAM dont la structure en peigne est hiérarchisée : les « dents » du peigne, ici appelées « branches du bus dRAM » sont séparées par des interrupteurs du « dos du peigne », ici appelé « tronc du bus dRAM ». Ces interrupteurs supplémentaires sont respectivement commandés par le signal Yj commandant les cellules dRAM de la même colonne.

Cette structure améliorée de dRAM est avantageuse en termes de capacité du bus dRAM. En effet, pour lire une ou plusieurs cellules situées sur la même colonne, seule la branche correspondante du bus est connectée à son tronc. De fait, la capacité Ctot utilisée dans les formules précédentes s'en trouve amoindrie car la capacité Cbus est limitée à la capacité du tronc et à celle d'une seule branche du bus.

Le gain nécessaire au niveau de Inv1, qui doit être de l'ordre de Ctot/Cell, s'en trouve amoindri aussi, facilitant la réalisation de Inv1 ou permettant l'augmentation du nombre de capacités de mémorisation dans la dRAM.

Que ce soit pour la dRAM matricielle de la Figure 6 ou pour la dRAM matricielle selon la variante de la Figure 7, les séquences de lecture ou écriture demeurent identiques, sauf pour ce qui concerne les signaux de commande de la dRAM.

Avantageusement, on active le(s) signal (signaux) Yj concerné(s) en début de séquence et on le(s) désactive en fin de séquence. Le créneau du signal ou des signaux Xi concerné(s) apparaît là où apparaissait le signal M dans les instructions pour dRAM linéaire décrites plus haut.

Par exemple, on indique ci-dessous la séquence permettant de lire simultanément les deux cellules Xi1Yj et Xi2Yj (i1 et i2 étant deux indices), situées sur la même colonne j, c'est-à-dire connectées à la même branche j du bus dRAM :

« Reset; R1-W1-Yj; W1'; ΔVinf ; Xi1-Xi2; Xi1'-Xi2'; R2; R2'; R1'-Yj' »

On rappelle que cette séquence permet d'obtenir le ET logique ou le OU logique entre les deux données lues, selon la valeur du décalage Δvinf.

De multiples variantes existent, qui sont encore plus nombreuses qu'avec la dRAM linéaire. Il est aussi possible de lire deux cellules situées sur deux branches différentes j1 et j2 du bus, donc sur deux colonnes différentes de la dRAM, mais sur la même ligne i, au moyen de l'instruction suivante :

« Reset; R1-W1-Yj1-Yj2; W1'; ΔVinf; Xi; Xi'; R2; R2'; R1'-Yj1'-Yj2' »

Les commutations des signaux X et Y s'y trouvent toujours au même endroit. Il est même possible de lire les cellules situées à l'intersection de plusieurs colonnes et plusieurs lignes. Mais cela n'est pas indispensable pour utiliser le PE, même si on pourra y trouver une utilité.

En fait, lors de l'utilisation pratique du processeur élémentaire, il est préférable d'organiser les données dans la dRAM pour que les calculs concernent des cellules mémoire situées sur la même branche du bus, ceci afin de minimiser les capacités électriques mises en oeuvre et ne pas avoir trop de réglages différents pour le décalage de tension Δvinf.

On notera ici que l'obtention des instructions d'écriture sur dRAM matricielle s'effectue en adaptant simplement les instructions utilisées avec une dRAM linéaire, ce que l'homme du métier réalisera sans difficulté.

La Figure 7 montre la dRAM matricielle améliorée connectée à la même unité booléenne que celle de la Figure 1, sauf Cinf qui a été déplacée du noeud E au noeud B, selon une possibilité décrite plus haut. En revanche, au sein de la dRAM apparaissent les ports de communication NW, NE, SE et SW correspondant à l'agencement de la Figure 4, permettant la communication de chaque processeur élémentaire avec ses 8 plus proches voisins.

La présente invention peut présenter des applications intéressantes notamment avec des capteurs matriciels, et plus particulièrement avec des capteurs d'images, rétines artificielles, etc., mais également avec tout autre type de capteur (capteur de pression, etc.)

Dans ce cas, on prévoit un processeur élémentaire pour une cellule ou pour un groupe limité de cellules du capteur, avec un agencement permettant une proximité géographique appropriée.

L'interfaçage de l'unité booléenne de chaque processeur élémentaire avec son ou ses capteurs peut être conçu de différentes manières, à la portée de l'homme du métier. Par exemple, une conversion analogique/numérique où les bits sont délivrés à l'entrée de l'unité booléenne en série est appropriée.

Bien entendu, de nombreuses variantes et modifications peuvent être apportées à l'invention.

En particulier, bien qu'une propriété importante d'une unité de traitement d'un processeur élémentaire selon l'invention soit d'être basée sur deux circuits de transformation et de mise en forme de signaux, il apparaîtra à l'homme du métier que ces deux circuits pourront être complétés par tout composant secondaire permettant d'en enrichir, améliorer, compenser ou fiabiliser le fonctionnement.

**Revendications**

**1.** Circuit de traitement de données, comprend en combinaison :

- une unité de traitement de données (UB) comprenant un premier et deuxième circuit (Inv1, Inv2) de transformation de signaux possédant chacun une entrée de signal et une sortie de signal, et une série d'interrupteurs commandés (R1, W1, R2, W2) reliés aux entrées et aux sorties desdits circuits de transformation, ladite unité de traitement de données comprenant par ailleurs une entrée (H) de signal binaire et une sortie (F) de signal binaire,
- une unité de mémorisation (dRAM) comprenant une série de capacités (Ccell) reliées à un agencement de bus de mémoire (bus dRAM) via une autre série d'interrupteurs (M1, ... Mp) et aptes à mémoriser chacune une donnée binaire, le bus étant relié à l'unité de traitement,
- un ensemble d'entrées pour des signaux de commande des interrupteurs commandés,

l'unité de traitement de données étant apte à effectuer au moins les opérations suivantes en réponse à des séquences données de signaux de commande :

* écrire dans une capacité une donnée binaire appliquée sur la ligne d'entrée,
* lire dans une capacité une donnée binaire qui y est mémorisée, et l'appliquer à la ligne de sortie, et
* combiner logiquement des données binaires mémorisées dans au moins deux capacités.

**2.** Circuit de traitement selon la revendication 1, dans lequel les circuits de transformation (Inv1, Inv2) sont des inverseurs ayant des réponses de type sigmoïde inversée (Ccell) au niveau du premier circuit de transformation.

**3.** Circuit de traitement selon la revendication 2, dans lequel un premier inverseur (Inv1) a son entrée et sa sortie reliées à l'agencement de bus de mémoire chacune par l'intermédiaire d'un interrupteur commandé respectif (R1 et W1).

**4.** Circuit de traitement selon l'une des revendications 2 et 3, dans lequel, l'unité de traitement comprend uniquement deux inverseurs (Inv1, Inv2) avec l'entrée de l'un reliée à la sortie de l'autre via un premier interrupteur commandé (W2) et l'entrée de l'autre reliée à la sortie de l'un via un second interrupteur commandé (R2).

**5.** Circuit de traitement selon l'une des revendications 3 et 4, comprenant une entrée pour une tension de compensation fixe ou variable (Vinf) qui est reliée via une capacité (Cinf) à une partie du circuit choisie parmi l'entrée du premier inverseur (Inv1) et l'agencement de bus de mémoire.

**6.** Circuit de traitement selon l'une des revendications 3 à 5, dans lequel au moins le premier inverseur est constitué par un comparateur dont une entrée positive reçoit une tension de seuil fixe ou variable (Vseuil).

**7.** Circuit de traitement selon l'une des revendications 1 à 6, lequel est apte à combiner logiquement, au niveau d'un premier circuit de transformation (Inv1), les données binaires mémorisées dans des capacités (Ccell) en réponse à des signaux de commande rendant passants des interrupteurs commandés de l'unité de mémorisation pour connecter électriquement lesdites capacités (Ccell) à l'agencement de bus mémoire (bus dRAM).

**8.** Circuit de traitement selon l'une des revendications 5 ou 6 et la revendication 7 prises en combinaison, dans lequel le type de combinaison logique varie en fonction de la valeur de la tension de compensation (Vinf) ou de la valeur de la tension de seuil (Vseuil).

**9.** Circuit selon l'une des revendications 1 à 8, dans lequel les capacités (Ccell) sont agencées en ligne, avec un bus de mémoire unique (bus dRAM) et un interrupteur unique (Mi) associé à chaque capacité.

**10.** Circuit selon l'une des revendications 1 à 8, dans lequel les capacités sont agencées en matrice, avec deux ensembles de lignes de bus (Xi, Yj) s'intersectant et une paire d'interrupteurs commandés (Ta, Tb) associée à chaque capacité (Ccell).

**11.** Circuit selon la revendication 10, dans lequel la paire d'interrupteurs comprend un premier interrupteur (Ta) dont les deux bornes de signal sont reliées entre la capacité (Ccell) et le bus (bus dRAM), et un second interrupteur (Tb) dont les deux bornes de signal sont reliées entre une première ligne de commande (Xi) et l'entrée de commande du premier interrupteur, et dont l'entrée de commande est reliée à une seconde ligne de commande (Yj).

**12.** Circuit selon les revendications 10 à 11, dans lequel l'agencement de bus de mémoire (bus dRAM) est réalisé par segmentation du bus en plusieurs parties (tronc bus dRAM, branches bus dRAM) séparées par des interrupteurs commandés respectifs (Figure 7).

**13.** Ensemble de traitement de données, **caractérisé en ce qu'**il comprend une grille de circuits de traitement selon l'une des revendications 1 à 12, et un dispositif de commande apte à appliquer auxdites entrées pour signaux de commande des signaux de commande communs à l'ensemble des circuits de traitement.

**14.** Ensemble selon la revendication 13, dans lequel chaque unité de traitement de données est apte à transférer des données binaires vers les unités de traitement voisines et à recevoir de celles-ci des données binaires via un jeu de ports (N, E, W, S ; NW, NE, SE, SW) connectés à un jeu de capacités de son unité de mémorisation associée.

**15.** Capteur matriciel, **caractérisé en ce qu'**il comprend un ensemble de cellules de détection notamment photosensibles formant sources de données, et un ensemble de traitement selon l'une des revendications 13 ou 14.

**Claims**

**1.** Data processing circuit, which comprises in combination:

- a data processing unit (UB) comprising a first and a second signal conversion circuit (Inv1, Inv2) which each have a signal input and a signal output, and a series of controlled switches (R1, W1, R2, W2) connected to the inputs and outputs of said conversion circuits, wherein said data processing unit further comprises a binary signal input (H) and a binary signal output (F),
- a memory unit (dRAM) comprising a series of capacitors (Ccell) connected to a memory bus arrangement (bus dRAM) via another series of switches (M1, Mp) that are each able to store a binary datum, wherein the bus is connected to the processing unit,
- a set of inputs for the control signals of the controlled switches,

wherein the data processing unit is able to carry out at least the following operations in response to control signal data sequences:

-- writing in a capacitor a binary datum applied to the input line,
-- reading in a capacitor a binary datum that is stored therein, and applying it to the output line, and
-- logically combining, in the first conversion circuit (Inv1), binary data which is stored in at least two capacitors (Ccell).

2. Processing circuit according to claim 1, in which the conversion circuits (Inv1, Inv2) are inverters which have inverted sigmoid type responses.

3. Processing circuit according to claim 2, in which a first inverter (Inv1) has its input and output connected to the memory bus arrangement each via a respective controlled switch (R1 and W1).

4. Processing circuit according to any one of claims 2 and 3, in which the processing unit only comprises two inverters (Inv1, Inv2) where the input of one is connected to the output of the other via a first controlled switch (W2) and the input of the other is connected to the output of the first via a second controlled switch (R2).

5. Processing circuit according to any one of claims 3 and 4, comprising an input for a compensation voltage (Vinf) that is connected via a capacitor (Cinf) to a portion of the circuit selected from the input of the first inverter (Inv1) and the bus memory arrangement.

6. Processing circuit according to any one of claims 3 to 5, in which at least the first inverter consists of a comparator of which one positive input receives a fixed or variable threshold voltage (Vthreshold).

7. Processing circuit according to any one of claims 1 to 6, that is able to combine logically, in a first conversion circuit (Inv1), the binary data stored in capacitors (Ccell) in response to control signals that render controlled switches of the memory unit conductive in order to electrically connect said capacitors (Ccell) to the bus memory arrangement (dRAM bus).

8. Processing circuit according to any one of claims 5 or 6 and claim 7 considered in combination, in which the type of logic combination varies on the basis of the compensation voltage (Vinf) or the value of the threshold voltage (Vthreshold).

9. Circuit according to any one of claims 1 to 8, in which the capacitors (Ccell) are laid out in line, with a single memory bus (dRAM bus) and a single switch (Mi) associated with each capacitor.

10. Circuit according to any one of claims 1 to 8, in which the capacitors are laid out in a matrix, with two sets of intersecting bus lines (Xi, Yj) and a pair of controlled switches (Ta, Tb) associated with each capacitor (Ccell).

11. Circuit according to claim 10, in which the pair of switches comprises a first switch (Ta), of which the two signal terminals are connected between the capacitor (Ccell) and the bus (dRAM bus), and a second switch (Tb), of which the two signal terminals are connected between a first control line (Xi) and the control input of the first switch, and of which the control input is connected to a second control line (Yj).

12. Circuit according to claims 10 to 11, in which the memory bus arrangement (dRAM bus) is formed by segmentation of the bus into several parts (dRAM bus trunk, dRAM bus branches) separated by respective controlled switches (Figure 7).

**13.** Data processing assembly, **characterised in that** it comprises an array of processing circuits according to any one of claims 1 to 12, and a control device which can apply to said control signal inputs control signals that are common to all of the processing circuits.

**14.** Assembly according to claim 13, in which each data processing unit is capable of transferring binary data to neighbouring processing units and of receiving binary data therefrom, via a set of ports (N, E, W, S; NW, NE, SE, SW) connected to a set of capacitors of its associated memory unit.

**15.** Matrix sensor, **characterised in that** it comprises a set of detection cells, which are photosensitive in particular and which form data sources, and a processing assembly according to any one of claims 13 or 14.

**Patentansprüche**

**1.** Datenverarbeitungsschaltung mit:

- einer Datenverarbeitungseinheit (UB) mit einer ersten und einer zweiten Signalumformungsschaltung (Inv1, Inv2), von denen jede einen Signaleingang und einen Signalausgang aufweist, und mit einer Reihe von gesteuerten Schaltern (R1,W1,R2,W2), die mit den Eingängen und den Ausgängen der Umformungsschaltungen verbunden sind, wobei die Datenverarbeitungseinheit außerdem einen binären Signaleingang (H) und einen binären Signalausgang (F) aufweist,
- einer Speichereinheit (dRAM) mit einer Reihe von Kapazitäten (Ccell), die über eine andere Reihe von Schaltern (M1,...,Mp) mit einer Speicherbusanordnung (dRAM-Bus) verbunden sind und jeweils binäre Daten speichern können, wobei der Bus mit der Verarbeitungseinheit verbunden ist,
- einer Anordnung von Eingängen für Steuersignale zur Steuerung der gesteuerten Schalter,

wobei die Datenverarbeitungseinheit mindestens eine der folgenden Operationen als Antwort auf vorgegebene Sequenzen von Steuersignalen ausführen kann:

* Schreiben von an der Eingangsleitung anliegenden binären Daten in eine Kapazität,
* Auslesen von gespeicherten binären Daten aus einer Kapazität und Zuführen derselben zu der Ausgangsleitung, und
* logisches Verknüpfen von in mindestens zwei Kapazitäten gespeicherten binären Daten in der ersten Umformungsschaltung (Imv1) (cell).

**2.** Verarbeitungsschaltung nach Anspruch 1, in welcher die Umformungsschaltungen (Inv1,Inv2) Inverter mit Antworten des inversen Sigmoid-Typs sind.

**3.** Verarbeitungsschaltung nach Anspruch 2, in welcher ein Eingang und ein Ausgang eines ersten Inverters (Inv1) über einen jeweiligen gesteuerten Schalter (R1 und W1) mit der Speicherbusanordnung verbunden sind.

**4.** Verarbeitungsschaltung nach einem der Ansprüche 2 und 3, in welcher die Verarbeitungseinheit nur zwei Inverter (Inv1, Inv2) aufweist, wobei der Eingang des einen über einen ersten gesteuerten Schalter (W2) mit dem Ausgang des anderen verbunden ist und der Eingang des anderen über einen zweiten gesteuerten Schalter (R2) mit dem Ausgang des einen verbunden ist.

**5.** Verarbeitungsschaltung nach einem der Ansprüche 3 und 4, mit einem Eingang für eine feste oder variable Kompensationsspannung (Vinf), der über eine Kapazität (Cinf) mit einem Teil der Schaltung verbunden ist, wobei dieser Teil der Eingang des ersten Inverters (Inv1) oder die Speicherbusanordnung sein kann.

**6.** Verarbeitungsschaltung nach einem der Ansprüche 3 bis 5, in welcher mindestens der erste Inverter aus einem Komparator besteht, dessen positiver Eingang eine feste oder variable Schwellenspannung (Vseuil) empfängt.

**7.** Verarbeitungsschaltung nach einem der Ansprüche 1 bis 6, mit der Fähigkeit einer logischen Verknüpfung der in Kapazitäten (Ccell) gespeicherten binären Daten in einer ersten Umformungsschaltung (Inv1) als Antwort auf Steuersignale, die die gesteuerten Schalter der Speichereinheit leitend machen, um die Kapazitäten (Ccell) mit der Speicherbusanordnung (dRAM-Bus) elektrisch zu verbinden.

**8.** Verarbeitungsschaltung nach einem der Ansprüche 5 oder 6 in Kombination mit Anspruch 7, in welcher sich der Typ der logischen Verknüpfung in Abhängigkeit vom Wert der Kompensationsspannung (Vinf) oder vom Wert der Schwellenspannung (Vseuil) ändert.

**9.** Schaltung nach einem der Ansprüche 1 bis 8, in welcher die Kapazitäten (Ccell) in einer Zeile angeordnet sind, mit einem einzigen Speicherbus (dRAM-Bus) und einem einzigen Schalter (Mi) für jede Kapazität.

**10.** Schaltung nach einem der Ansprüche 1 bis 8, in welcher die Kapazitäten in einer Matrix angeordnet sind, wobei sich zwei Busleitungsanordnungen (Xi,Yj) kreuzen und jeder Kapazität (Ccell) ein Paar gesteuerter Schalter (Ta, Tb) zugeordnet ist.

**11.** Schaltung nach Anspruch 10, in welcher das Schalterpaar einen ersten Schalter (Ta), der an seinen zwei Signalanschlüssen mit der Kapazität (Ccell) bzw. dem Bus (dRAM-Bus) verbunden ist, und einen zweiten Schalter (Tb) aufweist, der an seinen zwei Signalanschlüssen mit einer ersten Steuerleitung (Xi) bzw. dem Steuereingang des ersten Schalters verbunden ist und dessen Steuereingang mit einer zweiten Steuerleitung (Yj) verbunden ist.

**12.** Schaltung nach den Ansprüchen 10 bis 11, in welcher die Speicherbusanordnung (dRAM Bus) in mehrere Teile (dRAM-Bus-Stamm, dRAM-Bus-Zweige), die durch jeweilige gesteuerte Schalter getrennt sind, segmentiert ist (Figur 7).

**13.** Datenverarbeitungsanordnung, **dadurch gekennzeichnet, dass** sie eine gitterförmige Anordnung von Verarbeitungsschaltungen nach einem der Ansprüche 1 bis 12 und eine Steuervorrichtung aufweist, die Steuersignale, die allen Verarbeitungsschaltungen gemeinsam sind, an Steuersignaleingänge anlegen kann.

**14.** Anordnung nach Anspruch 13, in welcher jede Datenverarbeitungseinheit fähig ist, binäre Daten zu benachbarten Verarbeitungseinheiten zu senden und binäre Daten aus diesen herkommend über eine Gruppe von Anschlüssen (N,E,W,S;NW,NE,SE,SW), die mit einer Gruppe von Kapazitäten der zugeordneten Speichereinheit verbunden sind, zu empfangen.

**15.** Matrixsensor, **dadurch gekennzeichnet, dass** er eine Anordnung von Detektionszellen, insbesondere lichtempfindlichen Detektionszellen, die Datenquellen bilden, und eine Verarbeitungsanordnung nach einem der Ansprüche 13 oder 14 aufweist.

signal de
commande

Symbole d'un
interrupteur

Vout

**Inv1**

Vbf

Vin

Vbf

Caractéristique
tension-tension
de Inv1

Mp

N

Ccell

bus dRAM

M3    Ccell

M2    Ccell

Cbus

M1    Ccell

S

dRAM

B

R1    Vinf    W1    SH

Cinf

E    Inv1    F    d

C1

W2    R2

G    C2    H

Inv2    BP

g    EC

unité
booléenne
(UB)

## Figure 1

Vinf

Cinf

Vin    Vout    Vin    −    Vout

**Inv1**    +

Vseuil    **Inv1**

## Figure 2

**Figure 3**

**Figure 4**

Cellule dRAM linéaire

Cellule dRAM matricielle

## Figure 5

bus dRAM

## Figure 6

**Figure 7**

## RÉFÉRENCES CITÉES DANS LA DESCRIPTION

**Documents brevets cités dans la description**

- FR 2778764 A
- JP 10145680 A
- US 6608296 A
- FR 2583602 A
- FR 2683348 A, Zavidovique, Bernard et Devos
- FR 2777138 A, Paillet, Mercier et Bernard
- JP 7028988 A, Ishikawa et Yamada
- JP 8212073 A, Takayanagi, Yamada, Nakagami et Ishikawa

**Littérature non-brevet citée dans la description**

- **P. DUDEK ; P.J. HICKS.** A General Purpose Processor-per-Pixel Analog SIMD Vision Chip. *IEEE Transactions on Circuits and Systems-I: Fundamental Theory and Applications,* Janvier 2005, vol. 52 (1), 13-20
- **J.C. GEALOW ; C.G. SODINI.** A Pixel-Parallel Image Processor Using Logic Pitch-Matched to Dynamic Memory. *IEEE Journal of Solid-State Circuits,* Janvier 1999, vol. 34 (6), 831-839